**Europäisches Patentamt**

**European Patent Office**

**Office européen des brevets**

(19)

(11) Veröffentlichungsnummer: **0 116 826**

**B1**

(12) **EUROPÄISCHE PATENTSCHRIFT**

(45) Veröffentlichungstag der Patentschrift:
04.11.87

(51) Int. Cl.⁴: **G 01 N 27/28,** G 01 N 21/25,
G 01 N 21/64

(21) Anmeldenummer: **84100108.4**

(22) Anmeldetag: **07.01.84**

(54) **Anordnung zur Messung von Potentialdifferenzen.**

(30) Priorität: **21.01.83 DE 3301939**

(43) Veröffentlichungstag der Anmeldung:
**29.08.84 Patentblatt 84/35**

(45) Bekanntmachung des Hinweises auf die Patenterteilung:
**04.11.87 Patentblatt 87/45**

(84) Benannte Vertragsstaaten:
**AT BE CH FR GB IT LI LU NL SE**

(56) Entgegenhaltungen:
**EP-A-0 091 046
DE-A-3 019 030
DE-B-2 508 637**

**ANALYTICAL CHEMISTRY, Band 47, Nr. 1, Januar
1975, Washington W.R. HEINEMAN et al.
"Measurement of enzyme Eo' values by optically
transparent thin layer electrochemical cells",
Seiten 79-84
BERICHTE DER BUNSEN-GESELLSCHAFT, Band 11,
1973 W. MINDT et al. "Sensoren für Lactat und
Glucose", Seiten 804-808
Seite 33 aus dem Buch "Analysis with Ion-selective
Electrodes" von Peter Bailey, zweite Auflage
Heyden & Son Ltd, London (GB) 1980**

(73) Patentinhaber: **Max- Planck- Gesellschaft zur
Förderung der Wissenschaften e.V.,
Bunsenstrasse 10, D-3400 Göttingen (DE)**

(72) Erfinder: **Opitz, Norbert, Dr., Villigsterstrasse 6,
D-5840 Schwerte 5 (DE)**
Erfinder: **Lübbers, Dietrich Werner, Prof. Dr.,
Rheinlanddamm 201 a, D-4600 Dortmund 1 (DE)**

(74) Vertreter: **Hofmann, Hans Walter, Dr.,
Hauberisserstrasse 36, D-6200 Wiesbaden (DE)**

# Beschreibung

Die Erfindung betrifft eine Anordnung zur Messung von Potentialdifferenzen in Leitern 2. Klasse.

In Grenzschichten zwischen festen Körpern wie Metallen, ionenselektiven Gläsern, Membranen oder auch Flüssigkeiten einerseits und ionenhaltigen Flüssigkeiten, allgemein: Leitern 2. Klasse, andererseits entstehen häufig Potentialdifferenzen, deren Messung von besonderem Interesse ist. Grenzschichten dieser Art werden im folgenden als Potentialgeneratoren bezeichnet.

So gibt es beispielsweise ionenselektive Elektroden mit Kunststoffmembranen als Potentialgeneratoren (CAMMANN, Das Arbeiten mit ionenselektiven Elektroden, SPRINGER, Berlin 1973) an denen nach Eintauchen in ionenhaltige Lösungen Potentialdifferenzen entstehen, die der Aktivität der jeweils gemessenen Ionen entsprechen. Dadurch ist eine grosse Anzahl von Ionen bestimmbar.

Die zur Messung der Potentialdifferenzen angewendeten elektrischen Messmittel verursachen dabei ein schwerwiegendes Problem: da die Metalle, die die Verstärker- oder Anzeigeanordnungen mit den jeweiligen Messelektroden verbinden, beim Eintauchen in die ionenhaltigen Lösungen selbst Potentialdifferenzen bilden, entsteht eine Potentialkette, bei der eine eineindeutige Zuordnung der gemessenen Potentialdifferenz zum Potentialgenerator selbst oder aber ein rechnerischer Ausgleich der entstandenen Störpotentiale nicht immer möglich ist. Das ist insbesondere deshalb eine störende Einschränkung der Messgenauigkeit, weil die Störpotentiale immer in Abhängigkeit vom jeweiligen Messgut entstehen und beispielsweise bei biologischen Messobjekten kaum in Grösse und Zeitverlauf vorherbestimmbar sind.

Beipielsweise lassen sich die Drift und deren Absolutbetrag selbst für die umfangreich benutzte Kalomelelektrode oder auch die Ag/AgCl-Elektrode bei biologischen Objekten in vielen Fällen nicht vorhersagen.

Auch die Verwendung von Flüssigkeitsverbindungen zwischen Anzeigevorrichtung und Messonde, wie beispielsweise mittels Agarhebern, Fritten oder Kapillaren ergibt keine befriedigenden Lösungen des Problems, weil solche Verbindungen meist schnell kontaminiert sind, parasitäre Diffusionspotentiale bilden oder ihrerseits das Messgut kontaminieren.

Die Erfindung hat sich deshalb die Aufgabe gestellt, eine Anordnung zu schaffen, bei der der Einfluss von Störpotentialen für die Messung von Potentialen in Leitern 2. Klasse wesentlich verringert ist.

Sie löst diese Aufgabe dadurch, dass der die Potentialdifferenz erzeugende Potentialgenerator und ein einen Indikator enthaltender, elektrisch hochisolierender, chemisch inerter Potentialmessraum, dessen Indikator mit einer Änderung seiner optischen Eigenschaften auf eine Änderung der elektrischen Potentialdifferenz reagiert, jeweils eine Grenzfläche mit dem Leiter 2. Klasse (Messobjekt) aufweisen, dass ein Ausgleichsleiter den Potentialgenerator und den Potentialmessraum verbindet und dass eine Lichtmesseinrichtung zur Messung der Änderung der optischen Eigenschaften des Indikators vorgesehen ist.

Die Anordnung hat den Vorteil, dass nunmehr die am Potentialgenerator bestehende Potentialdifferenz rückwirkungsfrei gemessen werden kann, weil der Potentialmessraum chemisch nicht mit dem Messobjekt reagiert und weil die optische Signalerzeugung, sei es durch Änderung der Farbe, durch Sekundäremission, wie beispielsweise Lumineszenz, insbesondere Fluoreszenz oder andere optische Änderungen des verwendeten Indikators keine Änderung der bestehenden Potentialdifferenzen nach sich zieht, wie es bei den herkömmlichen Potentialmessmethoden mit Bezugselektroden der Fall ist.

Besonders hohe Signale entstehen dadurch, dass der Potentialmessraum als sehr dünne Schicht ausgebildet ist, weil dadurch hohe Feldstärken im Potentialmessraum bestehen. Insbesondere kann die Schicht monomolekular ausgebildet sein.

Solche monomolekularen Schichten ebenso wie Schichten aus mehreren Molekül005 mit definierter Schichtdicke können gut in bekannter Weise (KUHN, Physical Methods of Chemistry Vol. 1, WILEY, New York, 1972) hergestellt werden.

Dabei können die monomolekularen Schichten mit Indikatoren dotiert oder vollständig aus Indikatoren aufgebaut sein und es können Zwischenlagen aus indikatorfreien Schichten vorgesehen sein.

Die verwendeten Indikatoren können dabei eine Vorzugsrichtung aufweisen oder in einem flächigen oder auch räumlichen Muster angeordnet sein. Zur Herstellung solcher Muster können dabei verschiedene Indikatoren in Kombination verwendet sein, weil dadurch zum Beispiel verschiedene Messbereiche gleichzeitig erfasst werden können.

Ähnlich gute Präparationen sind möglich, wenn anstelle der sehr dünnen Schichten natürliche oder künstliche Membranen, wie beispielsweise Phospholipidmembranen oder indikatordotierte Grenzschichten zwischen zwei Leitern 2. Klasse verwendet werden.

Eine geringe Störanfälligkeit zeigt die Anordnung nach der Erfindung dann, wenn der Potentialgenerator sowie der Potentialmessraum räumlich benachbart sind.

Dadurch können exogene Störungen des elektrischen Feldes leicht ausgeschaltet werden.

Besonders kleine Anordnungen lassen sich erreichen, wenn der Potentialmessraum und der Potentialgenerator sandwichartig angeordnet sind und der Ausgleichsleiter eine Zwischenschicht bildet, oder wenn der Potentialgenerator und der Potentialmessraum konzentrisch zueinander angeordnet und der Potentialmessraum optisch an einen Lichtleiter angekoppelt ist.

Weitere Signalerhöhungen treten dadurch ein, dess die Potentialmessräume oder ihre unmittelbare Umgebung mit Mitteln zur Konzentration des elektrischen Feldes versehen sind.

Gute Anpassungen an verschiedenartige Messobjekte bei gleichzeitiger Vergrösserung der Messfläche lassen sich erreichen, wenn Potentialmessflächen und Potentialgeneratoren eine mosaikartige Fläche bilden.

Zur optischen Entkopplung von Messobjekt und Potentialmessraum können Schichten vorgesehen sein, die das Messobjekt vom Potentialmessraum durch Absorption, Reflexion oder Streuung, durch Änderung des Brechungsindex, des Polarisationsgrades oder durch Phasenänderung des Prüflichtes optisch entkoppeln.

Dadurch sind optische Rückwirkungen aus dem Messobjekt verringert.

Durch wenigstens zur Lichtmesseinrichtung hin lichtdurchlässige, elektrisch leitende Schichten am Potentialmessraum ist es möglich, eine Vorspannung oder eine Eichspannung in situ am Potentialmessraum anzulegen und dadurch die Anordnung zu eichen.

Um eine Zusammenfassung von Potentialgenerator und von Potentialmessraum zu erreichen, sind in dem als hochisolierende Membran ausgebildeten Potentialmessraum Mikropotentialgeneratoren angeordnet, die als Ionenkanäle in Form von mechanischen Poren, Dotierungen von Transportmolekülen (Carrierdotierungen), Metallpartikeln oder Partikeln aus ionenselektivem Glas ausgebildet sind.

Messtechnische Vorteile bringen Fluoreszenzindikatoren wegen des guten Signal-Rauschverhältnisses.

Ein besonders günstiger Indikator ist dabei 3,3'-dipropylthiadicarbocyanine-jodid.

In der Zeichnung, anhand derer die Erfindung nachstehend erläutert wird, sind weitere Einzelheiten der Erfindung schematisch dargestellt.

Es zeigen:

Fig.1a-d: Verschiedene Messanordnungen nach der Erfindung.

Fig.2a-i,k,m: Anordnungen zur Beeinflussung der Feldstärke.

Fig.3: Die Ausbildung der Anordnung zur Messung mit Lichtleitern.

Fig.4: Die Ausbildung eines Messmosaiks.

Fig.5a-b: Die Ausbildung schichtförmiger Messräume.

Fig.6a-b: Die Verwendung von Hilfselektroden und Schichten zur optischen Entkopplung.

Fig.7: Die Kombination von Potentialgeneratoren und Potentialmessräumen.

Fig.8: Eine sandwichartige Kombination von Potentialgenerator und Potentialmessraum.

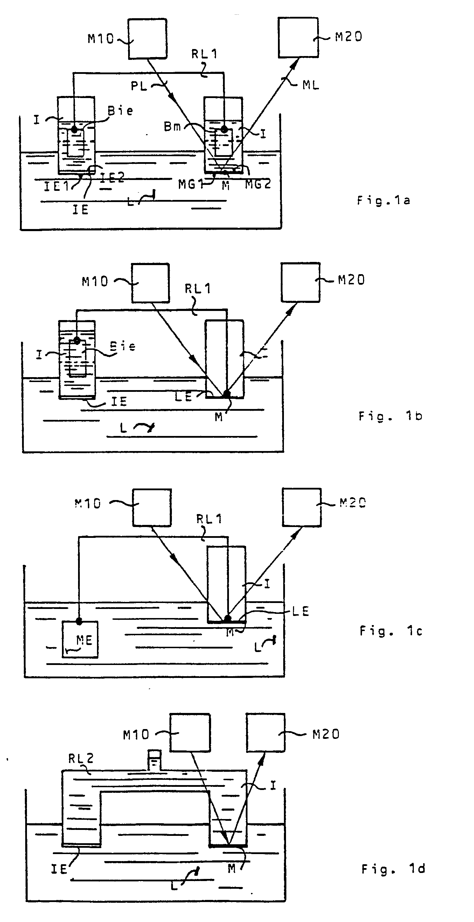

An einer Grenzschicht IE zu einer Ionen enthaltenden Lösung L mit der nach der Lösung L weisenden Fläche IE1 und der von der Lösung wegweisenden Fläche IE2, die in einer isolierenden Hülle I gemäss Fig.1a angeordnet ist, ergibt sich gemäss der NERNST-Gleichung ein Potential

$$(1) \quad E_i = E^{\circ}_i + \frac{RT}{Z_iF} \ln A_i$$

mit

$A_i$: Aktivität der gemessenen Ionenart
$Z_i$: Wertigkeit der gemessenen Ionenart
F: Faradaykonstante
R: Gaskonstante
T: Temperatur in Grad Kelvin
$E^{\circ}_i$: Standardpotential,

das über eine erste Bezugselektrode Bie mit einer metallischen Ausgleichsleitung RL1 auf eine zweite Bezugselektrode Bm geschaltet ist, die die Verbindung mit einem Potentialmessraum M herstellt, der hochisolierend und chemisch inert ist und die Begrenzungsflächen MG1 und MG2 aufweist. Die beiden Bezugselektroden Bie und Bm tauchen dabei in Leiter 2. Klasse ein. Durch diese Anordnung entsteht Potentialgleichheit sowohl auf der vom Messobjekt L abgewandten Seite IE2,MG2 als auch auf der zum Messobjekt L zeigenden Seite IE1,MG1 von Potentialmessraum M und Grenzschicht IE. Somit besteht die gleiche Potentialdifferenz über Potentialgenerator IE und über Potentialmessraum M.

Der Potentialmessraum M enthält einen optischen Indikator, der seine optischen Eigenschaften, wie etwa seine Lumineszenz, insbesondere Fluoreszenz, seine Absorption, sein Streuungsvermögen, seinen Brechungsindex, sein Phasenänderungsvermögen oder seinen Polarisationsgrad der über dem Potentialmessraum liegenden Potentialdifferenz ändert. Wird der Potentialmessraum mit Prüflicht PL aus einer Quelle M10 bestrahlt und das resultierende Messlicht ML durch eine Lichtmesseinrichtung M20 gemessen, dann kann damit die Änderung der optischen Eigenschaft des Indikators und entsprechend die Potentialdifferenz bestimmt werden.

Als Lichtquellen für das Prüflicht aus M10 können alle bekannten Lichtquellen, die den auf den jeweiligen Indikator passenden Wellenlängenbereich aufweisen, verwendet werden. Vorzugsweise haben sie die Form von Monochromatoren oder Polychromatoren mit Filtern oder Dispersionselementen. Weiterhin sind Laser wegen der guten Pulsfähigkeit und der Möglichkeit zu scharfer Bündelung oder LEDs wegen der geringen Grösse und Erwärmung von Vorteil.

Zur Fortleitung des Lichtes sind linsen- oder spiegeloptische Mittel oder Lichtleiter verwendbar.

Als Sensoren der Lichtmesseinrichtung M20 werden in bekannter Weise Photosensoren, wie beispielsweise Photomultiplier, oder es werden Photozellen, Photodioden oder ähnliche bekannte Vorrichtungen verwendet. Zur Messung von örtlichen Verteilungen können Arrays von Photozellen oder Vidikons eingesetzt werden.

Die Anordnung lässt sich dadurch verbessern, dass der Potentialmessraum M mit einer Leitelektrode LE versehen ist, die metallisch mit dem Ausgleichsleiter RL1 verbunden wird. Dadurch entfällt die Bezugselektrode Bm als eine erste Störquelle (Fig.1b). Die zweite Bezugselektrode Bie lässt sich als Störquelle eliminieren, wenn sich die Potentialdifferenz an einem Metall ME bildet und die metallische Ausgleichsleitung RL1 unmittelbar metallisch mit dem Potentialmessraum M verbunden wird (Fig.1c). Oder aber es wird ein Leiter 2. Klasse als Ausgleichsleitung RL2 verwendet (Fig.1d).

Eine besonders weit entwickelte Form von Potentialgeneratoren sind die ionenselektiven Elektroden. Solche Elektroden, die für eine sehr grosse Zahl von Ionenarten ausgebildet werden können, erzeugen über Membranen von einigen Mikrometern Dicke Potentialdifferenzen von einigen Millivolt. Wird nun der Potentialmessraum M in einer Dicke von einigen Nanometern hergestellt und mit Indikatoren beipielsweise aus Styrylfarbstoffen oder Merocyaninen versehen, dann entstehen entspechend dem elektrischen Feld zwischen den Flächenbegrenzungen MG1, MG2 des Potentialmessraumes M Feldstärken von etwa 10 exp 6 Volt/cm, die die Fluoreszenz dieser Indikatoren gut messbar ändern.

Potentialmessräume M der erforderlichen Dicke lassen sich als indikatordotierte künstliche oder natürliche Membranen, beispielsweise als Phospholipidmembranen, als Grenzschichten, als monomolekulare Schichten oder als sandwichartige, monomolekulare Mehrfachschichten mit bekannten Präparationsmethoden herstellen. Dabei können diese Schichten mit dem Indikator dotiert oder indikatorfrei sein, oder vollständig aus Indikatormolekülen bestehen. Die Indikatoren werden eingesiegelt, nämlich leckfrei eingelagert, also beispielsweise kovalent gebunden oder durch Einschliessung in Membranen geschützt. Dabei ist die Verwendung von Membranen mit niedriger Permeabilität für den abzuwehrenden Stoff erforderlich, wenn die Indikatoren, beispielsweise gegen Fluoreszenlöschung, etwa durch Sauerstoff, geschützt werden sollen. Unter anderem haben Membranen aus Polystyrol diese Eigenschaft.

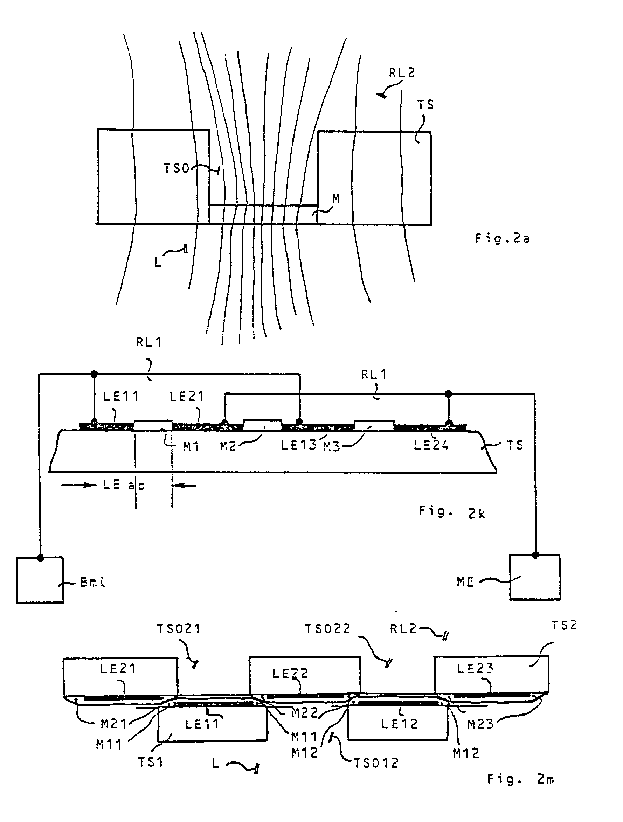

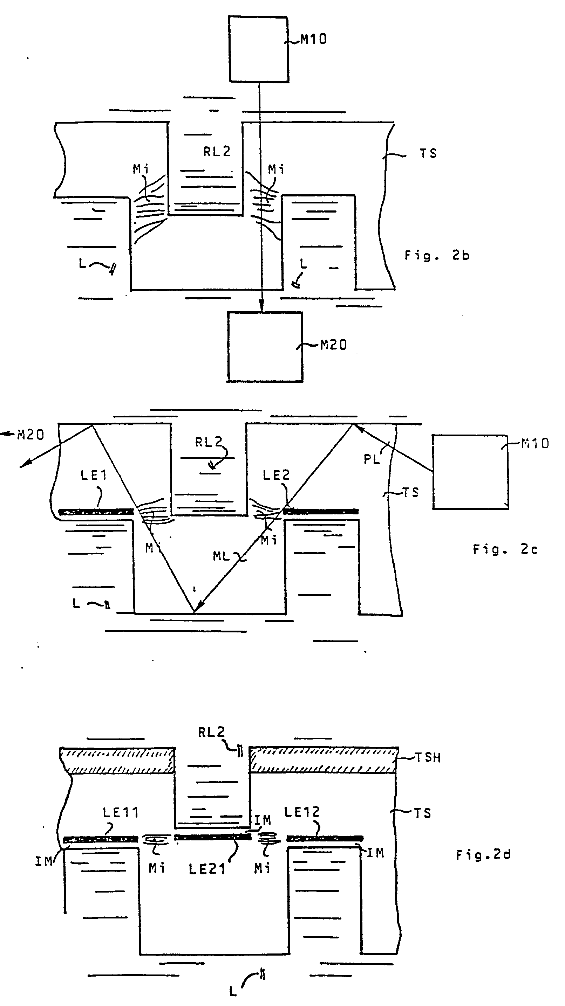

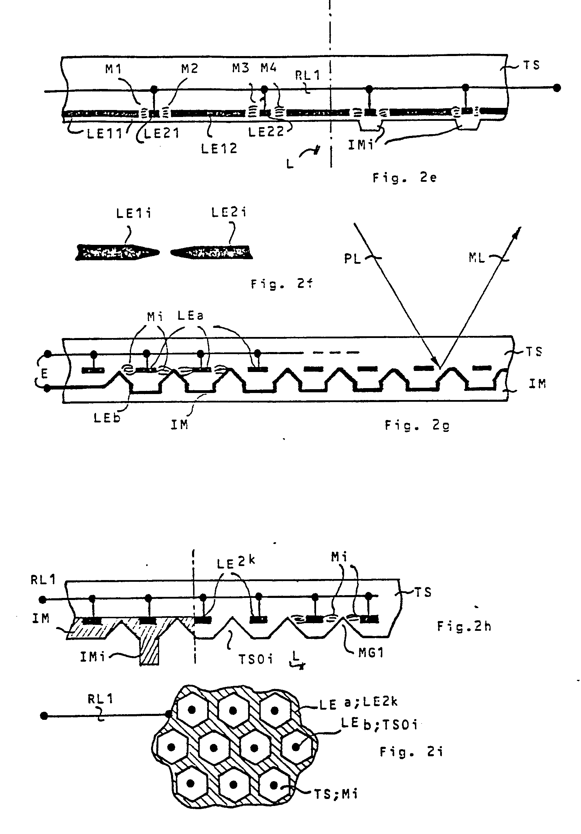

Es ist auch möglich, Mittel zur Beeinflussung des elektrischen Feldes zu verwenden. So ist gemäss Fig.2a, die im wesentlichen eine Teildarstellung von Fig.1d ist, das elektrische Feld durch Verwendung einer isolierenden Trägerschicht TS, in der eine Öffnung TSO für die flüssige Ausgleichsleitung RL2 angeordnet sind, verdichtet und dadurch die Feldstärke im Potentialmessraum M erhöht.

Auch gemäss Fig.2b bilden sich die elektrischen Feldlinien im wesentlichen in dem Bereich aus, in dem der kürzeste Abstand zwischen L und RL2 (entsprechend MG1-MG2) auftritt. In dieser Anordnung sind demnach die Potentialmessräume Mi ein Teil der Trägerschicht TS. Dargestellt ist in Fig.2b die Messung im Durchlicht.

Durch die in Fig.2c und Fig.2d dargestellten Anordnungen wird eine weitere Erhöhung des elektrischen Feldes durch die Verwendung von Leitelektroden LEi,LEik erreicht (Die LE1k sind dabei der Grenzfläche MG1, die LE2k der Grenzfläche MG2 zugeordnet). Dabei ist gemäss Fig.2d zusätzlich eine Trägerschicht TSH mit hoher mechanischer Festigkeit zur Aussteifung der Anordnung vorgesehen. Ausserdem sind hier wegen der besseren Herstellbarkeit die Isolatorschichten IM von aussen angebracht.

Bei Anordnungen, in denen die Trägerschicht TS und die Messräume Mi einstückig ausgebildet sind, kann auch gemäss Fig.2c das Messlicht stark seitlich eingestrahlt werden, sodass die Trägerschicht als Lichtleiter wirkt. Dabei ist auf gute Transparenz der Trägerschicht zu achten. Die Grenzflächen der Trägerschicht können aber auch mit einer Reflexionsschicht versehen sein.

In Fig.2e dienen die Leitelektroden LE1i zur Aufnahme des Potentials des Messobjektes L, während die Ausgleichsleitung RL1 die Verbindung zwischen den Elektroden LE2i und einer Metallelektrode als Potentialgenerator oder zu einer Bezugselektrode darstellt. Potentialmessräume Mi sind die Zwischenräume LE1i-LE2i. Zur Vermeidung von Verfälschungen des zu messenden Potentials sollen die Elektroden LE2i zum Messobjekt L hin eine möglichst geringe Fläche aufweisen. Sie können mit zusätzlichen Isolatorschichren IMi bedeckt sein.

Werden die Leitelektroden LE1i, LE2i beipielsweise aus Metallblechen durch Ätzen hergestellt, können sie leicht auf die Form gebracht werden, wie sie in Fig.2f dargestellt ist. Sie ergibt durch die schneidenförmige Ausbildung der Elektrodenkante hohe Feldstärken im Potentialmessraum.

Anstelle der Leitelektroden LE1i können gemäss Fig.2h auch Öffnungen TSOi verwendet werden, die entweder durch Einprägungen in die Trägerschicht TS oder durch Aufbringung einer Isolatorschicht IM auf die Trägerschicht TS entstehen. Im ersten Falle müssen die Leitelektroden LE2 in die Trägerschicht eingearbeitet sein. Im zweiten Falle können sie in bekannter Weise durch Aufdampfen oder HF-Sputtern aufgebracht und dann durch Lackierungsverfahren, Kunststoffbeschichtung oder Beschichtung im Hochvakuum elektrisch isolierend und chemisch inert abgedeckt werden. Dadurch entsteht die Schicht IM. Die Potentialmessräume Mi sind die Teile der Trägerschicht TS beziehungsweise der Isolierschicht IM, die durch die Lage der verwendeten elektrischen Leiter bestimmt sind.

Auch in dieser Ausführung der Erfindung entsteht eine mechanisch stabile Anordnung, obwohl die Dicken der Potentialmessräume sehr klein gehalten werden können.

Zur Messung auch beliebiger Potentialdifferenzen über metallische Zuleitungen können Anordnungen gemäss Fig.2g oder Fig.2k verwendet werden.

In Fig.2g, die aus Anordnungen gemäss Fig.2h durch Metallisieren der Seite MG1 und anschliessende Abdeckung durch eine Isolatorschicht IM hergestellt werden kann, werden die Potentialmessräume durch die zwischen den Leitelektroden LEa und der Metallisierung LEb liegenden Teile Mi gebildet. Die Metallisierung LEb wirkt gleichzeitig als Reflektor für Messlicht ML und Prüflicht PL.

Die Leitelektroden LEa; LE2k bilden gemäss Fig.2i vorzugsweise ein Netz aus hexagonalen Maschen, in die entweder die Metallisierung LEb oder das Messobjekt mittels der Öffnungen TSOi zentrisch hineinragt. Die gesamte Kantenlänge ist dann optische Messfläche. Je nach Bedarf können auch andere Netzformen verwendet werden.

Streifenförmige Leitelektroden LEik auf Trägerschichten TS sind im Querschnitt in Fig.2k gezeigt. Das elektrische Feld bildet sich dabei überwiegend zwischen den Kanten der Leitelektroden LE1i und LE2k in den Potentialmessräumen Mi aus. Die Feldstärken sind auch hier aufgrund der geringen Dicken der Leitelektroden LEik sehr hoch und können durch entsprechende Wahl der Elektrodenabstände LEab noch beeinflusst werden. Ein Vorteil auch dieser Ausbildung ist der gute mechanische Halt der Elektroden und der Potentialmessräume auf der Trägerschicht und deren mechanische Unempfindlichkeit.

Die Anordnungen in Fig.2g und Fig.2k können auch zur Messung beliebiger Potentiale ausserhalb von Leitern 2. Klasse verwendet werden.

Wenn ausschliesslich Leiter 2. Klasse verwendet werden sollen können auch zwei Trägerschichten TS1, TS2 gemäss Fig.2m angewendet werden. Die zu messende Potentialdifferenz bildet sich dabei über jeweils zwei Potentialmessräume M1i, M2i oder M1i, M2k aus. Die Leiter 2. Klasse füllen dabei die Öffnungen TSOik aus, das Potential entsteht durch Influenz in den Leitelektroden LEik.

Wenn grössere Potentialdifferenzen, etwa bis zu einigen Kilovolt, gemessen werden sollen, sind Potentialmessräume mit grösserer Dicke zu verwenden. Die Dicke wird dabei derart eingestellt, dass einerseits elektrische Durchschläge verhindert, andererseits aber eine möglichst hohe Feldstärke für den verwendeten Indikator erreicht wird.

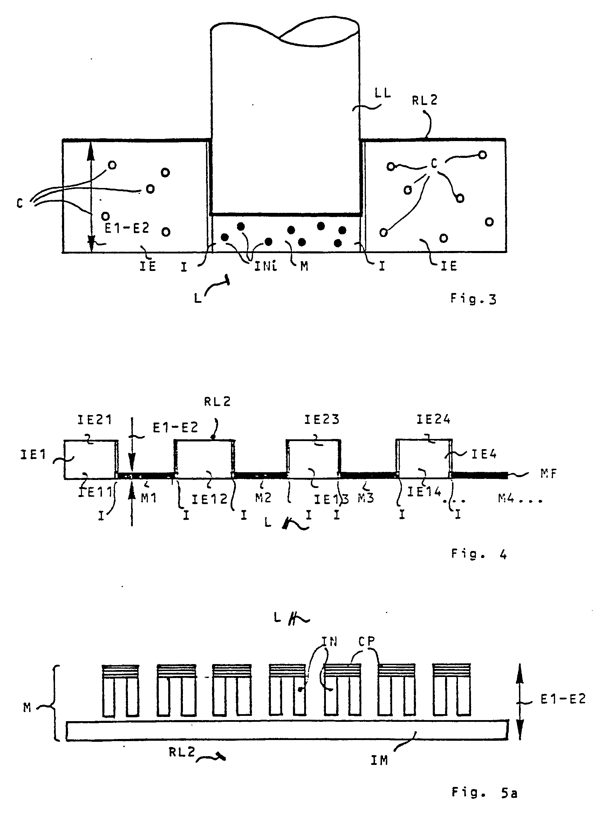

In Fig.3 sind analog Fig.1d eine ionenselektive Membran IE und ein Potentialmessraum M unmittelbar räumlich benachbart und durch Isolatoren I getrennt angeordnet und durch eine gemeinsame Rückleitung RL2 verbunden, sodass die von den ionenselektiven Transportmolekülen (Carriern) C erzeugte Potentialdifferenz E1-E2 unmittelbar über dem Potentialmessraum M entsteht. Die Fluoreszenz im Potentialmessraum M durch die Indikatormoleküle INi, die einen oder mehrere Indikatortypen mit verschiedenen charakteristischen Frequenzen umfassen können, wird über einen Lichtleiter LL erzeugt und erfasst und mit einer nicht gezeichneten Lichtmesseinrichtung gemessen.

In Fig.4 ist ein Mosaik MF von nebeneinanderliegenden Potentialmessräumen Mi und, durch Isolatoren I getrennt, Potentialgeneratoren IEk mit Begrenzungsflächen IEik dargestellt, mit dem die Potentialmessfläche vergrösserbar und das Signal-Rauschverhältnis der Anordnung zu verbessern ist. Dabei können die Elemerte des Mosaiks so angeordnet werden, wie es das Messobjekt jeweils erfordert, sodass solche Anordnungen sehr gut an verschiedenartige Messobjekte anpassbar sind.

Fig.5a zeigt eine sehr dünne Schicht (Monolayer), die aus einer Moleküllage eines Indikators IN mit einem Chromophor CP auf einer Schicht IM besteht und die die Indikatormoleküle in gerichteter Form enthält. Da solche Schichten hydrophob ausbildbar sind, können sie, ohne sich chemisch in einer wässrigen Lösung L zu ändern, sehr dünn ausgebildet sein, sodass eine sehr hohe Feldstärke und damit ein gutes Signal entsteht.

Monomolekulare Schichten dieser Art bilden sich auch selbsttätig in Grenzflächen zweier verschiedener Leiter 2. Klasse aus.

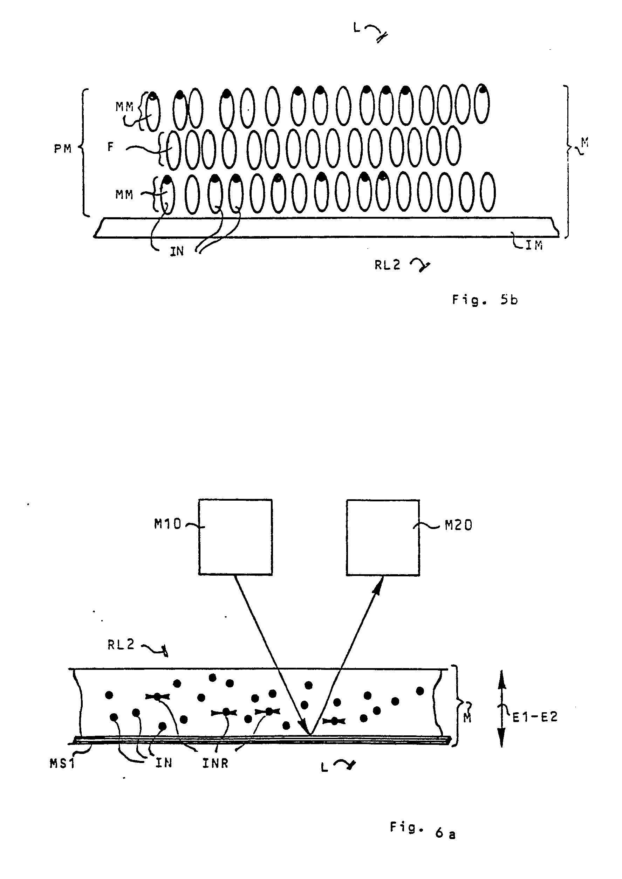

Mit den bekannten Präparationsmethoden können aber auch Schichten PM mit mehreren Moleküllagen und einer definierten Schichtdicke nach Fig.5b aufgebaut werden. Dabei sind beispielsweise die monomolekularen Lagen MM mit Indikatoren IN dotiert und durch eine indikatorfreie Schicht F getrennt.

Die Schichten können weiterhin derart ausgebildet werden, dass die Reaktionszeit auf Potentialänderungen im Messobjekt sehr klein wird, sodass sich Modulationen des Lichtes anwenden lassen, die in bekannter Weise eine entsprechend wirksame elektrische Signalverarbeitung, wie beispielsweise Wechselspannungsverstärkung, Lock-in Gleichrichtung, oder Bandbreitenverringerung erlauben.

Bei Verwendung besonders empfindlicher Indikatoren ist es damit auch möglich, das zu messende Potential sowie das Prüflicht in Form von Einzelimpulsen oder von Impulsserien, beispielsweise mittels eines Lasers, aufzubringen, um die Belastung des Indikators entsprechend gering zu halten. Der Indikator folgt dabei weitgehend dem Impulsverlauf der Potentialänderung. Die Form des Potentialpulses kann dabei zur Signalunterscheidung gegenüber den Rauschspannungen verwendet werden.

Zur Optimierung des Zeitverhaltens der erfindungsgemässen Anordnungen werden die Flächeninhalte der Grenzflächen des Potentialmessraumes oder gegebenenfalls die Flächeninhalte der den Potentialmessraum begrenzenden Leitelektroden auf die Dicke des Potentialmessraumes abgestimmt.

Soll nämlich der Impulsverlauf eines Potentielimpulses bestimmbar bleiben, ist die RC-Zeit und damit die elektrische Kapazität der Anordnung von Bedeutung. Diese lässt sich durch Wahl der Dielektrizitätskonstanten der den Potentialmessraum bildenden Stoffe oder auch durch Serien-Parallelschaltung von mehreren kleineren Potentialmessräumen einstellen und damit auf die Impulszeit anpassen.

Auch der elektrische Widerstand der Zuleitungen oder der Leiter 2. Klasse können zur Abstimmung der RC-Zeit verwendet werden.

Nach Fig.6a kann eine Schicht MS1 auf der dem Messobjekt L zugewandten Seite des Potentialmessraumes durch Herstellung mit entsprechenden optischen Eigenschaften zur optischen Entkopplung des Potentialmessraumes M vom Messobjekt L verwendet werden. Das ist zur Vermeidung von optischen Rückwirkungen aus dem Messobjekt L erforderlich. Die Entkopplung kann durch Ausbildung von MS1 als reflektierende, brechende, streuende oder als absortierende Schicht oder Schicht mit kombinierten Eigenschaften in bekannter Weise erfolgen, wobei Phasenänderungen des Lichtes, Änderungen der Polarisation, Lumineszenz und Energietransfer des eingestrahlten Lichtes ursächlich für die Änderung der Schichteigenschaft sein können.

Eine stark seitliche Einstrahlung des Prüflichtes hat den Vorteil dass die Wechselwirkung mit dem Messobjekt von vornherein verringert ist. Die Wechselswirkung wird bei Einstrahlung unterhalb des Grenzwinkels der Totalreflexion weiter minimiert.

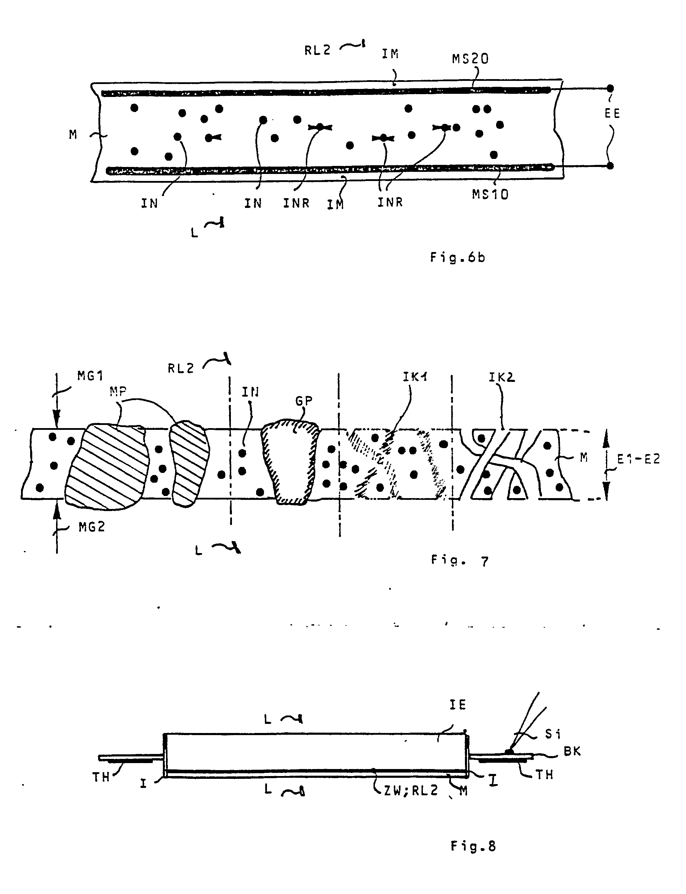

Werden nach Fig.6b Schichten MS20 und MS10 vorgesehen, die mit einer isolierenden Membran IM umgeben sind, können zusätzlich Vorspannungen angelegt, oder durch Anlegen von Eichspannungen EE auch Eichungen des Potentialmessraumes in situ vorgenommen werden. Die Eichspannungen können dabei periodisch aufgebracht und das dadurch entstehende Signal zur Differenz- oder Verhältnisbildung mit dem Messignal verwendet werden.

Die nach der Lichtmesse einrichtung hin liegende Schicht MS20 muss optisch durchlässig sein. Soll bei Messobjekten, die keine optische Rückwirkung auf das Messlicht oder das Prüflicht zeigen, im Durchlichtverfahren gemessen werden, Fig.2b, muss auch die Schicht MS10 optisch durchlässig sein.

Die Schichten MS10, IM auf der Seite des Messobjektes L können in bekannter Weise zusätzlich zur optischen Entkopplung ausgebildet sein.

Weiterhin kann dem Potentialmessraum M ein Referenzindikator INR zugefügt werden, der sich durch die zu messende Potentialdifferenz in seinen optischen Eigenschaften nicht ändert. Dadurch ist es möglich, durch eine Verhältnisbildung von Messignal zu Referenzsignal in bekannter Weise optische Änderungen, beispielsweise Trübungen im optischen Signalpfad oder Ausbleichen des Indikators, oder aber elektrische Änderungen, wie beispielsweise Empfindlichkeitsänderungen des Sensors oder Änderungen der Verstärkung, zu eliminieren.

Potentialmessraum und Potentialgenerator können in einer Anordnung nach Fig.7 zusammengefasst sein, wenn der hochisolierende Potentialmessraum M mit Mikropotentialgeneratoren MP, GP, IK1, IK2 versehen ist.

Durch solche Mikropotentialgeneratoren, die als Ionenkanäle, beispielsweise in Form von mechanischen Poren IK2 oder als Dotierungen mit Transportmolekülen (Carrierdotierungen) IK1 ausgebildet sein können, oder die als Metallpartikel MP oder als Partikel aus ionenselektivem Glas GP vorliegen, bildet sich die Potentialdifferenz E1-E2 an den Grenzflächen MG1,MG2, die mit den Indikatoren IN optisch angezeigt wird.

Da der Potentialmessraum M selbst chemisch inert und hochisolierend ist, bildet er kein eigenes Potential. Das entstehende Potential rührt vielmehr ausschliesslich von den Mikropotentialgeneratoren her.

Ein weiterer Aufbau einer kombinierten Anordnung zeigt Fig.8. Hier ist der Potentialmessraum M über einen als Zwischenschicht ZW ausgebildeten Leiter RL2 mit dem Potentialgenerator IE verbunden.

Hier sind auch Mittel TH zur thermischen Stabilisierung, wie beispielsweise elektrische Heizungen, sowie weitere Sensoren Si auf einem gemeinsamen Baukörper BK angeordnet.

Solche Einrichtungen zur thermischen Stabilisierung, aber auch Anordnungen von Kombinationen verschiedener Potentialmessräume oder von Kombinationen mit anderen physikalischen Sensoren sind in entsprechender Weise möglich.

Die beschriebenen Anordnungen lassen sich auch zur Messung in Fermentern oder Oxygenatoren verwenden. Sie können dabei auch als Messtrecken zur Prozessteuerung geschaltet sein.

## Patentansprüche

1. Anordnung zur Messung von durch Potentialgeneratoren (IE, IEk) erzeugten Potentialdifferenzen in Leitern 2. Klasse, (L) mit denen die Potentialgeneratoren (IE, IEk) eine Grenzfläche (IE1, IE2) aufweisen, dadurch gekennzeichnet,
dass ein einen Indikator (IN, INi) enthaltender, elektrisch hochisolierender, chemisch inerter Potentialmessraum (M, Mi, Mik), dessen Indikator (IN, INi) mit einer Änderung seiner optischen Eigenschaften auf eine Änderung der elektrischen Potentialdifferenz reagiert, eine weiters Grenzfläche (MG1) mit dem Leiter 2. Klasse (L) aufweist, dass ein Ausgleichsleiter (RL1, RL2) den Potentialgenerator (IE, IEk) und den Potentialmessraum (M, Mi, Mik) verbindet und dass eine Lichtmesseinrichtung (M10, M20) zur Messung der Änderung der optischen Eigenschaften des Indikators (IN, INi) vorgesehen ist.

2. Anordnung nach Anspruch 1 dadurch gekennzeichnet, dass der Potentialmessraum (M, Mi, Mik) als sehr dünne Schicht ausgebildet ist.

3. Anordnung nach Anspruch 2, dadurch gekennzeichnet, das der Potentialmessraum als monomolekulare Schicht (MM) ausgebildet ist.

4. Anordnung nach Anspruch 3, dadurch gekennzeichnet, dass mehrere monomolekulare Schichten (PM; MM) übereinander angeordnet sind.

5. Anordnung nach Anspruch 3 oder 4, dadurch gekennzeichnet, dass die Schichten (PM) indikatordotiert sind.

6. Anordnung nach Anspruch 3 oder 4, dadurch gekennzeichnet, dass die Schichten vollständig aus Indikatormolekülen (IN-CP) bestehen.

7. Anordnung nach Anspruch 5 oder 6, dadurch gekennzeichnet, dass zusätzlich indikatorfreie Schichten (F) vorgesehen sind.

8. Anordnung nach einem der Ansprüche 3 bis 7, dadurch gekennzeichnet, dass die Indikatormoleküle (IN, INi, INR, IN-CP) in einer Vorzugsrichtung ausgerichtet sind.

9. Anordnung nach einem der Ansprüche 1, 2, 7 oder 8, dadurch gekennzeichnet, dass der Potentialmessraum (M, Mi, Mik) als Phospholipidmembrane ausgebildet ist.

10. Anordnung nach einem der Ansprüche 1 bis 9, dadurch gekennzeichnet, dass die Indikatoren (IN, INi, INR, IN-CP) ein flächiges oder räumliches Muster bilden.

11. Anordnung nach Anspruch 1 bis 10, dadurch, gekennzeichnet, dass Kombinationen verschiedener Indikatoren (IN, INi, INR, IN-CP) vorgesehen sind.

12. Anordnung nach einem der Ansprüche 1 bis 11, dadurch gekennzeichnet, dass Potentialgeneratoren (IEk) und der Potentialmessräume (M, Mi, Mik) räumlich benachbart und die Begrenzungsflächen IE1k-IE2k sowie MG1-MG2 jeweils gegeneinander isoliert sind.

13. Anordnung nach Anspruch 12, dadurch gekennzeichnet, dass der Potentialmessraum (M) und der Potentialgenerator (IE) konzentrisch angeordnet und der Potentialmessraum optisch an einen Lichtleiter (LL) angekoppelt ist.

14. Anordnung nach Anspruch 12, dadurch gekennzeichnet, dass der Potentialmessraum (M) und der Potentialgenerator (IE) sandwichartig argeordnet sind und der Ausgleichsleiter (RL2) eine Zwischenschicht (ZW) bildet.

15. Anordnung nach einem der Ansprüche 1 bis 14, dadurch gekennzeichnet, dass Potentialmessräume (Mi) und Potentialgeneratoren (IEi) eine mosaikartige Fläche (MF) bilden.

16. Anordnung nach einem der Ansprüche 1 bis 15 dadurch gekennzeichnet, dass der Potentialmessraum (M, Mi, Mik) mit Mitteln (TSO, TSOi, LEi, LEik, LEa, LEb) zur Beeinflussung des elektrischen Feldes versehen ist.

17. Anordnung nach einem dem Ansprüche 1 bis 16, dadurch gekennzeichnet, dass Leitelektroden (LEi, LEik, LEa, LEb) vorgesehen sind, deren Kanten oder Spitzen den Potentialmessraum (Mi, Mik) bestimmen.

18. Anordnung nach einem der Anspruche 1 bis 17, dadurch gekennzeichnet, dass Öffnungen (TSOi) vorgesehen sind, deren Kanten oder Spitzen den Potentialmessraum (Mi, Mik) bestimmen.

19. Anordnung nach einem der Ansprüche 1 bis 18, dadurch gekennzeichnet, dass die Kanten der Leitelektroden (LE, LEi, LEik, LEa, LEb) als Schneiden ausgebildet sind.

20. Anordnung nach einem der Ansprüche 1 bis 19, dadurch gekennzeichnet, dass eine Kombination von Leitelektroden (LEi, LEik) und Öffnungen (TSOi) vorgesehen ist, durch die der Potentialmessraum (Mi, Mik) bestimmt ist.

21. Anordnung nach einem der Ansprüche 1 bis 20, dadurch gekennzeichnet, dass die Mittel (LEi, LEik, LEa, LEb, TSOi) flächig periodisch auf einer Trägerschicht (TS) angeordnet sind.

22. Anordnung nach einem der Ansprüche 1 bis 21, dadurch gekennzeichnet, dass die Trägerschicht (TS) gemeinsam mit dem Potentialmessraum (M, Mi, Mik) ein einstückiger, indikatordotierter, transparenter Isolatorkörper ist.

23. Anordnung nach einem der Ansprüche 1 bis 22, dadurch gekennzeichnet, dass die Mittel (TSOi, LEi, LEik, LEa, LEb) hexagonale Kanten haben.

24. Anordnung nach einem der Ansprüche 1 bis 23, dadurch gekennzeichnet, dass zwei, die Leitelektroden und die Potentialmessräume tragende Trägerschichten (TS1, TS2) derart mit den Leitelektroden gegeneinandergesetzt sind, dass die Potentialmessräume (Mik) zwischen den Kanten der gegenüberliegenden Leitelektroden (Lik) gebildet sind.

25. Anordnung nach einem der Ansprüche 1 bis 24, dadurch gekennzeichnet, dass das Messobjekt (L) vom Potentialmessraum (M) durch Absorption, Reflexion oder Streuung des Prüflichtes optisch entkoppelt ist.

26. Anordnung nach einem der Ansprüche 1 bis 25, dadurch gekennzeichnet, dass zur Lichtmesseinrichtung (M10, M20) hin lichtdurchlässige, elektrisch leitende und isolierte Schichten (MS10, MS20) vorgesehen sind, die mit einem elektrischen Hilfspotential (EE) verbindbar sind.

27. Anordnung nach Anspruch 25, dadurch gekennzeichnet, dass der Potentialmessraum (M) durch eine Schicht (MS1) optisch entkoppelt ist.

28. Anordnung nach einem der Ansprüche 1 bis 27, dadurch gekennzeichnet, dass der Potentialgenerator (IE) ein Metall (ME) ist.

29. Anordnung nach einem der Ansprüche 1 bis 27, dadurch gekennzeichnet, dass der Potentialgenerator (IE) ein ionenselektives Glas ist.

30. Anordnung nach einem der Ansprüche 1 bis 27, dadurch gekennzeichnet, dass der Potentialgenerator (IE) eine ionenselektive Membran ist.

31. Anordnung nach Anspruch 28, dadurch gekennzeichnet, dass der Ausgleichsleiter (RL1) metallisch ausgebildet ist.

32. Anordnung nach Anspruch 1, dadurch gekennzeichnet, dass der Ausgleichsleiter (RL2) als Leiter 2. Klasse ausgebildet ist.

33. Anordnung nach einem der Ansprüche 1 bis 32 dadurch gekennzeichnet, dass als Indikator (IN, INi, INR, IN-CP) ein Lumineszenzindikator, insbesondere ein Fluoreszenzindikator verwendet ist.

34. Anordnung nach Anspruch 33, dadurch gekennzeichnet, dass als Indikator (IN, INi, INR, IN-CP) ein Merocyanin verwendet ist.

35. Anordnung nach Anspruch 33, dadurch gekennzeichnet, dass als Indikator (IN, IN, INR, IN-CP) ein Styrylfarbstoff verwendet ist.

36. Anordnung nach Anspruch 33, dadurch gekennzeichnet, dass als Indikator (IN, INi, INR, IN-CP) 3,3'-dipropylthiadicarbocyanine-jodid verwendet ist.

37. Anordnung nach einem der Ansprüche 1 bis 36, dadurch gekennzeichnet, dass im Potentialmessraum (M, Mi, Mik) ein Refersnzindikator (INR) angeordnet ist.

38. Anordnung nach einem der Ansprüche 1 bis 37, dadurch gekennzeichnet, dass die Indikatoren (IN, INi, INR) in den Messraum (Mi, M, Mik) eingesiegelt sind.

39. Anordnung nach Anspruch 1 bis 38, dadurch gekennzeichnet, dass der Potentialmessraum (M, Mi, Mik) aus einem Stoff mit niedriger Permeabilität für Sauerstoff besteht.

40. Anordnung nach einem der Ansprüche 1 bis 39, dadurch gekennzeichnet, dass die Indikatoren (IN, INi, INR) kovalent im Potentialmessraum (M, Mi, Mik) gebunden sind.

41. Anordnung nach Anspruch 38, dadurch gekennzeichnet, dass die Indikatoren (IN, INi, INR) in Membranen eingeschlossen sind.

42. Anordnung nach Anspruch 1, dadurch gekennzeichnet, dass in einem als hochisolierende Membran ausgebildeten Potentialmessraum (M, Mi, Mik) Mikropotentialgeneratoren (MP, GP, IK1, IK2) angeordnet sind.

43. Anordnung nach Anspruch 42, dadurch gekennzeichnet, dass die Mikropotentialgeneratoren (IK2) als mechanische Poren ausgebildet sind.

44. Anordnung nach Anspruch 42, dadurch gekennzeichnet, dass die Mikropotentialgeneratoren (IK1) durch Dotierungen von Transportmolekülen (Carrierdotierungen) gebildet sind.

45. Anordnung nach Anspruch 42, dadurch gekennzeichnet, dass die Mikropotentialgeneratoren Metallpartikel (MP) sind.

46. Anordnung nach Anspruch 42, dadurch gekennzeichnet, dass die Mikropotentialgeneratoren als Partikel aus ionenselektivem Glas (GP) ausgebildet sind.

47. Anordnung nach einem der Ansprüche 1 bis 46, dadurch gekennzeichnet, dass das Prüflicht (PL) periodisch moduliert ist.

48. Anordnung nach einem der Ansprüche 1 bis 46, dadurch gekennzeichnet, dass das zu messende Potential (E1-E2) und/oder das Prüflicht (PL) in Form von Einzelimpulsen oder von Impulsserien aufgebracht ist.

49. Anordnung nach Anspruch 47 oder 48, dadurch gekennzeichnet, dass der Flächeninhalt der Begrenzung des Potentialmessraumes oder der den Potentialmessraum begrenzenden Leitelektroden derart auf die Dicke des Potentialmessraumes abgestimmt ist, dass die RC-Zeit des Porentialmessraumes kleiner als die Impulszeit ist.

50. Anordnung nach einem der Ansprüche 47 bis 49, dadurch gekennzeichnet, dass das Dielektrikum des Potentialmessraumes derart gewählt ist, dass die RC-Zeit des Potentialmessraumes kleiner als die Impulszeit ist.

51. Anordnung nach Anspruch 26, dadurch gekennzeichnet, dass ein Eichpotential periodisch an die Hilfselektroden angelegt, und dessen optisches Signal als Referenzsignal verwendet wird.

52. Anordnung nach Anspruch 1 dadurch gekennzeichnet, dass die Lichtmesseinrichtung (M10, M20) zur Messung im Auflicht angeordnet ist.

53. Anordnung nach Anspruch 1 dadurch gekennzeichnet, dass die Lichtmesseinrichtung (M10, M20) zur Messung im Durchlicht angeordnet ist.

54. Anordnung nach Anspruch 1 dadurch gekennzeichnet, dass die Schicht (TS) als Lichtleiter ausgebildet und die Lichtmesseinrichtung (M10, M20) zur seitlichen Durchstrahlung der Schicht (TS) angeordnet ist.

55. Anordnung nach einem der Ansprüche 1 bis 54, dadurch gekennzeichnet, dass das Ausgangssignal der Lichtmesseinrichtung (M10, M20) zur Prozeßsteuerung verwendet ist.

56. Anordnung nach einem der Ansprüche 1 bis 55, dadurch gekennzeichnet, dass im gleichen Messobjekt (L) neben einem Potentialmessraum (M, Mi, Mik) weitere Sensoren (Si) für andere physikalische oder biologische Parameter vorgesehen sind.

57. Anordnung nach einem der Ansprüche 1 bis 56, dadurch gekennzeichnet, dass Thermostabilisierungen (TH) für die verwendeten Sensoren (Si) und den Potentialmessraum (M, Mi, Mik) vorgesehen sind.

58. Anordnung nach einem der Ansprüche 56 oder 57, dadurch gekennzeichnet, dass die Sensoren (Si) und der Potentialmessraum (M, Mi, Mik) auf einem gemeinsamen Baukörper (BK) angeordnet sind.

59. Anordnung nach Ansprüch 1 dadurch gekennzeichnet, dass ein Laser als Lichtquelle der Lichtmesseinrichtung (M10) vorgesehen ist.

60. Anordnung nach Anspruch 1 dadurch gekennzeichnet, dass ein LED als Lichtquelle der Lichtmesseinrichtung (M10) vorgesehen ist.

61. Anordnung nach Anspruch 1 dadurch gekennzeichnet, dass ein Array von Fotozellen als Lichtsensor der Lichtmesseierichtung (M20) vorgesehen ist.

62. Anordnung nach Anspruch 1 dadurch gekennzeichnet, dass ein Vidikon als Lichtsensor der Lichtmesseinrichtung (M20) vergesehen ist.

## Claims

1. Arrangement for the measurement of potential differences in second class conductors (L), the potential differences generated by potential generators (IE, IEk) having a bordering plane (IE1, IE2) with the second class conductor (L) characterized by a chemically inert potential measuring space (M, Mi, Mik) containing an indicator (IN, INi) which is reacting to the electrical potential difference by a change of optical properties and having an additional bordering plane (MG1) with the second class conductor (L), and by a balancing conductor (RL1, RL2) connecting the potential measuring space (Mx, Mi, Mk) with the potential generator (IE, IEk) and comprising a light measuring device (M10, M20) for measuring the change in optical properties of the indicator (IN, INi).

2. An arrangement according to Claim 1, characterized in that the potential measuring area (M, Mi, Mik) is designed as a very thin film.

3. An arrangement according to Claim 2, characterized in that the potential measuring area is designed as a monomolecular film (MM).

4. An arrangement according to Claim 3, characterized in that several monomolecular films (PM, MM) are arranged one above the other.

5. An arrangement according to Claim 3 or 4, characterized in that the films (PM) are indicator-doped.

6. An arrangement according to Claim 3 or 4, characterized in that the films completely comprise indicator molecules (IN-CP).

7. An arrangement according to Claim 5 or 6, characterized in that indicator-free films (F) are provided in addition.

8. An arrangement according to one of Claims 3 to 7, characterized in that the indicator molecules (IN, INi, INR, IN-CP) are aligned in a preferred direction.

9. An arrangement according to one of Claims 1, 2, 7 or 8, characterized in that the potential measurement area (M, Mi, Mik) is designed as a phosphatide membrane.

10. An arrangement according to one of Claims 1 to 9, characterized in that the indicators (IN, INi, INR, IN-CP) form a two-dimensional or three-dimensional pattern.

11. An arrangement according to Claims 1 to 10, characterized in that combinations of various indicators (IN, INi, INR, IN-CP) are provided.

12. An arrangement according to one of Claims 1 to 11, characterized in that potential generators (IEk) and the potential measurement areas (M, Mi, Mik) are three-dimensionally adjacent and the delimiting surfaces IE1k-IE2k and MG1-MG2 are insulated from each other in both cases.

13. An arrangement according to Claim 12, characterized in that the potential measurement area (M) and the potential generator (IE) are concentrically arranged and the potential measuring area is optically coupled to a light conductor (LL).

14. An arrangement according to Claim 12, characterized in that the potential measurement area (M) and the potential generator (IE) are arranged in sandvich form and the compensating conductor (RL2) forms an intermediate film (ZW).

15. An arrangement according to one of Claims 1 to 14, characterized in that potential measurement areas (Mi) and potential generators (IEi) form a mosaic-like surface (MF).

16. An arrangement according to one of Claims 1 to 15, characterized in that the potential measurement area (M, Mi, Mik) is provided with means for influencing the electrical field.

17. An arrangement according to one of Claims 1 to 16, characterized in that conducting electrodes (LEi, LEik, LEa, LEb) are provided whose edges or tips delimit the potential measurement area (Mi, Mik).

18. An arrangement according to one of Claims 1 to 17, characterized in that openings (TSO1) are provided whose edges or tips delimit the potential measurement area (Mi, Mik).

19. An arrangement according to one of Claims 1 to 18, characterized in that the edges of the conducting electrodes (LE, LEi, LEik, LEa, LEb) are designed as blade edges.

20. An arrangement according to one of Claims 1 to 19, characterized in that a combination of conducting electrodes (LEi, LEik) and openings (TSOi) is provided by which the potential measurement area (Mi, Mik) is delimited.

21. An arrangement according to one of Claims 1 to 20, characterized in that the means (LEi, LEik, LEa, LEb, TSOi) are arranged twodimensionally and periodically on a carrier film (TS).

22. An arrangement according to one of Claims 1 to 21, characterized in that the carrier film (TS) together with the potential measurement area (M, Mi, Mik) is a one-piece, indicator-doped, transparent insulating element.

23. An arrangement according to one of Claims 1 to 22, characterized in that the means (TSOi, LEi, LEik, LEa, LEb) have hexagonal edges.

24. An arrangement according to one of Claims 1 to 23, characterized in that two carrier films (TS1, TS2) carrying the conducting electrodes and the potential measurement areas are placed in opposition to the conducting electrodes in such a way that the potential measurement areas (Mik) are formed between the edges of the opposite conducting electrodes (Lik).

25. An arrangement according to one of Claims 1 to 24, characterized in that the measured object (L) is optically uncoupled from the potential measurement area (M) by absorption, reflection or dispersal of the test light.

26. An arrangement according to one of Claims 1 to 25, characterized in that translucent, electrically conductive and insulated films (MS10, MS20) are provided facing the light measurement direction (M10, M20) and are connectable to an electrical auxiliary potential (EE).

27. An arrangement according to Claim 25, characterized in that the potential measurement area (M) is optically uncoupled by a film (MSi).

28. An arrangement according to one of Claims 1 to 27, characterized in that the potential generator (IE) is a metal (ME).

29. An arrangement according to one of Claims 1 to 27, characterized in that the potential generator (IE) is an ion-selective glass.

30. An arrangement according to one of Claims 1 to 27, characterized in that the potential generator (IE) is an ion-selective membrane.

31. An arrangement according to Claim 28, characterized in that

the compensating conductor (RL1) is designed in metal.

32. An arrangement according to Claim 1, characterized in that the compensating conductor (RL2) is designed as a 2nd class conductor.

33. An arrangement according to one of Claims 1 to 32, characterized in that a luminescent indicator, particularly a fluorescent indicator, is used as the indicator (IN, INi, INR, IN-CP).

34. An arrangement according to Claim 33, characterized in that a merocyanine is used as the indicator (IN, INi, INR, IN-CP).

35. An arrangement according to Claim 33, characterized in that a styryl dye is used as the indicator (IN, INi, INR, IN-CP).

36. An arrangement according to Claim 33, characterized in that 3.3′ dipropylthiadicarbocyanine iodide is used as the indicator (IN, INi, INR, IN-CP).

37. An arrangement according to one of Claims 1 to 36, characterized in that a reference indicator (INR) is arranged in the potential measurement area (M, Mi, Mik).

38. An arrangement according to one of Claims 1 to 37, characterized in that the indicators (IN, INi, INR) are sealed into the potential measurement area (M, Mi, Mik).

39. An arrangement according to Claims 1 to 38, characterized in that the potential measurement area (M, Mi, Mik) comprises a substance with low permeability for oxygen.

40. An arrangement according to one of Claims 1 to 39, characterized in that the indicators (IN, INi, INR) are covalently bonded in the potential measurement area (M, Mi, Mik).

41. An arrangement according to Claim 38, characterized in that the indicators (IN, INi, INR) are enclosed in membranes.

42. An arrangement according to Claim 1, characterized in that micropotential generators (MP, GP, IK1, IK2) are arranged in a potential measurement area (M, Mi, Mik) designed as a highly insulating membrane.

43. An arrangement according to Claim 42, characterized in that the micropotential generators (IK2) are designed as mechanical pores.

44. An arrangement according to Claim 42, characterized in that the micropotential generators (IK1) are formed by doping transport molecules (carrier doping).

45. An arrangement according to Claim 42, characterized in that

the micropotential generators are metal particles (MP).

46. An arrangement according to Claim 42, characterized in that the micropotential generators are designed as particles of ion-selective glass (GP).

47. An arrangement according to one of Claims 1 to 46, characterized in that the test light (PL) is periodically modulated.

48. An arrangement according to one of Claims 1 to 46, characterized in that the potential to be measured (E1-E2) and/or the test light (PL) is provided in the form of individual pulses or series of pulses.

49. An arrangement according to Claim 47 or 48, characterized in that the surface content of the limit to the potential measurement area or of the conducting electrodes delimiting the potential measurement area is adjusted to the thickness of the potential measurement area such that the RC time of the potential measurement area is shorter than the pulse time.

50. An arrangement according to Claim 47 to 49, characterized in that the dielectric of the potential measurement area is selected such that the RC time of the potential measurement area is shorter than the pulse time.

51. An arrangement according to Claim 26, characterized in that a calibration potential is periodically applied to the auxiliary electrodes and its optical signal is used as a reference signal.

52. An arrangement according to Claim 1, characterized in that the light measuring device (M10, M20) is arranged in the incident light for measurement.

53. An arrangement according to Claim 1, characterized in that the light measuring device (M10, M20) is arranged in the transmitted light for measurement.

54. An arrangement according to Claim 1, characterized in that the film (TS) is designed as a light conductor and the light measuring device (M10, M20) is arranged for lateral irradiation of the film (TS).

55. An arrangement according to one of Claims 1 to 54, characterized in that the output signal of the light measuring device (M10, M20) is used for process control.

56. An arrangement according to one of Claims 1 to 55, characterized in that the same measurement object (L) has, in addition to a potential measurement area (M, Mi, Mik), further sensors (Si) for other physical or biological parameters.

57. An arrangement according to one of Claims 1 to 56, characterized in that thermostabilizers (TH) are provided for the sensors (Si) used and for the potential measurement area (M, Mi, Mik).

58. An arrangement according to one of Claims 56 or 57, characterized in that the sensors (Si) and the potential measurement area (M, Mi, Mik) are arranged on a common element (BK).

59. An arrangement according to Claim 1, characterized in that a laser is provided as the light source for the light measuring device (M10).

60. An arrangement according to Claim 1, characterized in that an LED is provided as the light source for the light measuring device (M10).

61. An arrangement according to Claim 1, characterized in that an array of photoelectric cells is provided as the light sensor of the light measuring device (M20).

62. An arrangement according to Claim 1, characterized in that a vidicon is provided as the light sensor of the light measuring device (M20).

**Revendications**

1. Disposition pour mesurer le différence de potentiel dans un conducteur de classe seconde (L), le différence de potentiel generée par un generateur de potentiel (IE, IEk) qui a des bords commune (IE1, IE2) avec le conducteur de classe seconde,

characterisée

par une espace de mesure pour le différence de ppotentiel (M, Mi, Mik), qui est chimiquement inert est qui contiens indicateurs (IN, INi), qui changent la qualité optique selon le potentiel electrique et qui a une bord additionelle (MG1) avec le conducteur de classe seconde (L) et un conducteur compenseteur (RL1, RL2) connectant l'espace de mesure (Mx, Mi, Mk) avec le generateur de potentiel (IE, IEk) et comprenant une photometre (M10, M20) pour mesurer le changement de lumière par les indicateurs (IN, INi).

2. Disposition selon la revendication 1, caractérisée en ce que l'espace de mesure de potentiel (M, Mi, Mik) est conçu sous forme de couche très mince.

3. Disposition selon la revendication 2, caractérisée en ce que l'espace de mesure de potentiel est conçu sous forme de couche monomoléculaire (MM).

4. Disposition selon la revendication 3, caractérisée en ce que plusieurs couches monomoléculaires (PM; MM) sont superposées.

5. Disposition selon la revendication 3 ou 4, caractérisée en ce que les couches (PM) sont dotées d'un indicateur.

6. Disposition selon la revendication 3 ou 4, cararactérisée en ce que les couches sont entièrement composées de molécules d'indicateur (IN-CP).

7. Disposition selon la revendication 5 ou 6, caractérisée en ce que des couches exemptes d'indicateur (F) sont prévues en sus.

8. Disposition selon l'une des revendications 3 à 7, caractérisée en ce que les molécules d'indicateur (IN, INi, INR, IN-CP) ont une orientation préférentielle.

9. Disposition selon l'une des revendications 1, 2, 7 ou 8, caractérisée en ce que l'espace de mesure de potentiel (M, Mi, Mik) est conçu sous forme de membrane phospholipide.

10. Disposition selon l'une des revendications 1 à 9, caractérisée en ce que les indicateurs (IN, INi, INR, IN-CP) forment un modèle à deux ou trois dimensions.

11. Disposition selon les revendications 1 à 10, caractérisée en ce que des combinaisons de divers indicateurs (IN, INi, INR, IN-CP) sont prévues.

12. Disposition selon l'une des revendications 1 à 11, caractérisée en ce que les générateurs de potentiel (IEk) et les espaces de mesure de potentiel (M, Mi, Mik) sont voisins dans l'espace et que les périphéries IE1k-IE2k et MG1-MG2 sont isolées les unes des autres.

13. Disposition selon la revendication 12, caractérisée en ce que l'espace de mesure de potentiel (M) et le générateur de potentiel (IE) sont disposés de façon concentrique et que l'espace de mesure de potentiel est couplé optiquement à un guide de lumière (LL).

14. Disposition selon la revendication 12, caractérisée en ce que l'espace de mesure de potentiel (M) et le générateur de potentiel (IE) sont disposés en sandwich et que le guide compensateur (RL2) forme une couche intermédiaire (ZW).

15. Disposition selon l'une des revendications 1 à 14, caractérisée en ce que les espaces de mesure de potentiel (Mi) et les générateurs de potentiel (IEi) forment une surface mosaïquée (MF).

16. Disposition selon l'une des revendications 1 à 15, caractérisée en ce que l'espace de mesure de potentiel (M, Mi, Mik) est doté de moyens (TSO, TSOi, LEi, LEik, LEa, LEb) destinés à influer sur le champ électrique.

17. Disposition selon l'une des revendications 1 à 16, caractérisée en ce que des électrodes conductrices (LEi, LEik, LEa, LEb) sont prévues dont les bords ou les pointes déterminent l'espace de mesure de potentiel (Mi, Mik).

18. Disposition selon l'une des revendications 1 à 17, caractérisée en ce que des ouvertures (TSOi) sont prévues dont les bords ou pointes déterminent l'espace de mesure de potentiel (Mi, Mik).

19. Disposition selon l'une des revendications 1 à 18, caractérisée en ce que les bords des électrodes conductrices (LE, LEi, LEik, LEa, LEb) sont conçus sous forme d'arêtes vives.

20. Disposition selon l'une des revendications 1 à 19, caractérisée en ce qu'une combinaison d'électrodes conductrices (LEi, LEik) et d'ouvertures (TSOi) est prévue, laquelle détermine l'espace de mesure de potentiel (Mi, Mik).

21. Disposition selon l'une des revendications 1 à 20, caractérisée en ce que les moyens (LEi, LEik, LEa, LEb, TSOi) sont disposés périodiquement en nappe sur une couche porteuse (TS).

22. Disposition selon l'une des revendications 1 à 21, caractérisée en ce que la couche porteuse (TS) forme, avec l'espace de mesure de potentiel (M, Mi, Mik), un corps isolant monobloc, transparent et doté d'indicateurs.

23. Disposition selon l'une des revendications 1 à 22, caractérisée en ce que les moyens (TSOi, LEi, LEik, LEa, LEb) comportent des bords hexagonaux.

24. Disposition selon l'une des revendications 1 à 23, caractérisée en ce que deux couches porteuses (TS1, TS2), qui supportent les électrodes conductrices et les espaces de mesure de potentiel, sont opposées aux électrodes conductrices de telle manière que les espaces de mesure de potentiel (Mik) sont formés entre les bords des électrodes conductrices opposées (Lik).

25. Disposition selon l'une des revendications 1 à 24, caractérisée en ce que l'objet de mesure (L) est découplé optiquement de l'espace de mesure de potentiel (M) par absorption, réflexion ou dispersion de la lumière de contrôle.

26. Disposition selon l'une des revendications 1 à 25, caractérisée en ce que sont prévues, en direction du photomètre (M10, M20), des couches transparentes, conductrices d'électricité et isolées (MS10, MS20) qui sont reliables à un potentiel électrique auxiliaire (EE).

27. Disposition selon la revendication 25, caractérisée en ce que l'espace de mesure de potentiel (M) est découplé optiquement par une couche (MS1).

28. Disposition selon l'une des revendications 1 à 27, caractérisée en ce que le générateur de potentiel (IE) est un métal (ME).

29. Disposition selon l'une des revendications 1 à 27, caractérisée en ce que le générateur de potentiel (IE) est un verre sélectif d'ions.

30. Disposition selon l'une des revendications 1 à 27, caractérisée en ce que le générateur de potentiel est une membrane sélective d'ions.

31. Disposition selon la revendication 28, caractérisée en ce que le conducteur compensateur (RL1) est de conception métallique.

32. Disposition selon la revendication 1, caractérisée en ce que le conducteur compensateur (RL2) est conçu sous forme de conducteur de 2e classe.

33. Disposition selon l'une des revendications 1 à 32, caractérisée en ce qu'un indicateur de luminescence, notamment un indicateur de fluorescence, est utilisé comme indicateur (IN, INi, INR, IN-CP).

34. Disposition selon la revendication 33, caractérisée en ce qu'une mérocyanine est utilisée comme indicateur (IN, INi, INR, IN-CP).

35. Disposition selon la revendication 33, caractérisée en ce qu'un colorant au styrène est utilisé comme indicateur (IN, INi, INR, IN-CP).

36. Disposition selon la revendication 33, caractérisée en ce que du 3, 3' iodure-dipropylthiadicarbocyanine- est utilisé comme indicateur (IN, INi, INR, IN-CP).

37. Disposition selon l'une des revendications 1 à 36, caractérisée en ce qu'un indicateur de référence (INR) est disposé dans l'espace de mesure de potentiel (M, Mi, Mik).

38. Disposition selon l'une des revendications 1 à 37, caractérisée en ce que les indicateurs (IN, INi, INR) sont scellés dans l'espace de mesure (Mi, M, Mik).

39. Disposition selon les revendications 1 à 38, caractérisée en ce que l'espace de mesure de potentiel (M, Mi, Mik) se compose d'une substance à faible pérméabilité à l'oxygène.

40. Disposition selon l'une des revendications 1 à 39, caractérisée en ce que les indicateurs (IN, INi, INR) sont covalents dans l'espace de mesure de potentiel (M, Mi, Mik).

41. Disposition selon la revendication 38, caractérisée en ce que les indicateurs (IN, INi, INR) sont contenus dans des membranes.

42. Disposition selon la revendication 1, caractérisée en ce que des générateurs de micropotentiel (MP, GP, IK1, IK2) sont disposés dans un espace de mesure de potentiel (M, Mi, Mik) conçu comme membrane hautement isolante.

43. Disposition selon la revendication 42, caractérisée en ce que les générateurs de micropotentiel (IK2) sont conçus comme pores mécaniques.

44. Disposition selon la revendication 42, caractérisée en ce que les générateurs de micropotentiel (IK1) sont formés par des dopages de molécules de transport (dopages d'agents véhiculaires).

45. Disposition selon la revendication 42, caractérisée en ce que les générateurs de micropotentiel sont des particules métalliques (MP).

46. Disposition selon la revendication 42, caractérisée en ce que les générateurs de micropotentiel sont conçus sous forme de particules faites de verre sélectif d'ions (GP).

47. Disposition selon l'une des revendications 1 à 46, caractérisée en ce que la lumière de contrôle (PL) est périodiquement modulée.

48. Disposition selon l'une des revendications 1 à 46, caractérisée en ce que le potentiel à mesure (E1-E2) et/ou la lumière de contrôle (PL) est fourni sous forme d'impulsions individuelles ou de séries d'impulsions.

49. Disposition selon la revendication 47 ou 48, caractérisé en ce que l'aire de la limitation de l'espace de mesure de potentiel ou des électrodes conductrices limitant l'espace de mesure de potentiel est adaptée de telle manière à l'épaisseur de l'espace de mesure de potentiel que le temps RC de l'espace de mesure de potentiel est plus réduit que le temps d'impulsion.

50. Disposition selon l'une des revendications 47 à 49, caractérisée en ce que le diélectrique de l'espace de mesure de potentiel a été de choisi de telle manière que le temps RC de l'espace de mesure de potentiel est plus réduit que le temps d'impulsion.

51. Disposition selon la revendication 26, caractérisée en ce qu'un potentiel d'étalonnage est appliqué périodiquement aux électrodes auxiliaires et que son signal optique est utilisé comme signal de référence.

52. Disposition selon la revendication 1, caractérisée en ce que le photomètre (M10, M20) est disposé dans la lumière incidente pour la mesure.

53. Disposition selon la revendication 1, caractérisée en ce que le photomètre (M10, M20) est disposé dans la lumière transmise.

54. Disposition selon la revendication 1, caractérisée en ce que la couche (TS) est conçue sous forme de guide de lumière et que le photomètre (M10, M20) est disposé pour l'irradiation latérale de la couche (TS).

55. Disposition selon l'une des revendications 1 à 54, caractérisée en ce que le signal initial du photomètre (M10, M20) est utilisé pour la commande de processus industriels.

56. Disposition selon l'une des revendications 1 à 55, caractérisée en ce que, dans le même objet de mesure (L), d'autres détecteurs (Si) sont, outre un espace de mesure de potentiel (M, Mi, Mik), prévus pour d'autres paramètres physiques ou biologiques.

57. Disposition selon l'une des revendications 1 à 56, caractérisée en ce que des thermostabilisations (TH) sont prévues pour les détecteurs utilisés (Si) et l'espace de mesure de potentiel (M, Mi, Mik).

58. Disposition selon l'une des revendications 56 ou 57, caractérisée en ce que les détecteurs (Si) et l'espace de mesure de potentiel (M, Mi, Mik) sont disposés sur un corps commun (BK).

59. Disposition selon la revendication 1, caractérisée en ce qu'un laser est prévu comme source lumineuse du photomètre.

60. Disposition selon la revendication 1, caractérisé en ce qu'une DEL est prévue comme source lumineuse du photomètre (M10).

61. Disposition selon la revendication 1, caractérisée en ce qu'un système de cellules photo-électriques est prévu comme détecteur de lumière du photomètre (M20).

62. Disposition selon la revendication 1, charactérisée en ce qu'une vidicon est prévue comme détecteur de lumière du photomètre (M20).

Fig.1a

Fig. 1b

Fig. 1c

Fig. 1d

Fig.2a

Fig. 2k

Fig. 2m

M10

RL2

TS

Mi          Mi

L          L          Fig. 2b

M20

M20

RL2

LE1          LE2          PL          M10

TS

Mi

Mi          ML          Fig. 2c

L

RL2

TSH

LE11          IM          LE12          TS

IM          LE21          IM          Fig.2d

Mi          Mi

L

Fig. 2e

Fig. 2f

Fig. 2g

Fig.2h

Fig. 2i

Fig. 3

Fig. 4

Fig. 5a

L

Fig. 5b

Fig. 6a

Fig.6b

Fig. 7

Fig.8